# EUROPÄISCHE PATENTSCHRIFT

(11) **EP 0 542 095 B1**
(45) Veröffentlichungstag und Bekanntmachung des Hinweises auf die Patenterteilung: **01.02.1995**
(21) Anmeldenummer: 92118778.7
(22) Anmeldetag: 02.11.1992
(51) Int. Cl.: H05K 13/04

(54) **Vorrichtung zum Befestigen von Bauelementen in mehrpoligen Leiterplatten**
Apparatus for securing components to multipole printed circuit boards
Dispositif pour la fixation de composants aux plaques de circuit imprimé multipolaires

(30) Priorität: 11.11.1991 DE 4137025
(43) Veröffentlichungstag der Anmeldung: 19.05.1993
(73) Patentinhaber: SIEMENS AKTIENGESELLSCHAFT, 80333 München (DE)
(72) Erfinder: Pedall, Friedrich, Dipl.-Ing., W-7528 Karlsdorf (DE); Rietschle, Herbert, W-7518 Bretten (DE)

(56) Entgegenhaltungen:
- DE-B- 1 122 118
- GB-A- 2 186 825

## Beschreibung

Bei der automatischen Bestückung von Leiterplatten mit bedrahteten Bauelementen werden die einzelnen Bauelemente von einem Greifer erfaßt, durch eine programmgesteuerte Relativbewegung zwischen Leiterplatte und Greifer in eine vorgegebene Bestückposition verfahren und dort so abgesenkt, daß die Anschlußbeinchen des Bauelements in die zugeordneten Bohrungen der Leiterplatte eingeführt werden. Für die Befestigung der Bauelemente bis zum Einlöten ihrer Anschlußbeinchen befindet sich unterhalb der jeweiligen Bestückposition eine in der Praxis als Unterwerkzeug bezeichnete Vorrichtung, welche die aus der Leiterplatte nach unten herausragenden Anschlußbeinchen umbiegt. Dabei benötigen sowohl der Greifer als auch das Unterwerkzeug im Hinblick auf ihren mechanischen Aufbau und ihre Funktionsweise einen gewissen Freiraum, der von anderen Bauelementen nicht belegt sein darf. Bei der Bestückung mit IC-Bauelementen sind diese als Bestückschatten bezeichneten Freiräume besonders groß, da hier die Abmessungen von Greifer und Unterwerkzeug in der Regel auf die maximal mögliche IC-Bestücklänge ausgelegt sind. Das Plazieren von SMD-Bauelementen in bekannter Siebdruck-Löttechnik ist somit innerhalb dieser benötigten Bestückschattenbereiche nicht möglich. Müssen im Bestückschattenbereich Bauelemente plaziert werden, so können IC-Bauelemente nur von Hand am Ende der Bestückreihenfolge nachgesetzt werden, welches jedoch ein sehr teurer und häufig mit Fehlern behafteter Arbeitsschritt ist.

Das Problem des Bestückschattens kann durch eine Reihenfolge der Bestückung gelöst werden, bei welcher nacheinander IC-Bauelemente, Axial-Bauelemente, Radial-Bauelemente und schließlich alle von Hand aufzubringenden Bauelemente auf der Leiterplatte plaziert werden. Diese Lösung ist jedoch nur dann möglich, solange vorher kein Bauelement auf der Leiterplatte angeordnet ist. Bei einer vorbestückten Leiterplatte treten zwangsläufig die durch die Bestückschatten bedingten Probleme auf. Bauelemente mit einem bei der automatischen Bestückung unzulässig großen Bestückschatten können dann nur von Hand bestückt werden. Damit entfallen aber auch die bei einer Fertigung mit hohem Qualitätsniveau übliche Durchsteckkontrolle der Anschlußbeinchen in der Leiterplatte und die durch eine NC-Steuerung bedingte genaue Lageposition der Bauelemente auf der Leiterplatte. Dies führt dann andererseits zu einem erhöhten Prüf- und Reparaturaufwand.

Sollen auf eine vorbestückte Leiterplatte zusätzlich Bauelemente automatisch aufgebracht werden, so ist dies nur mit Greifern und Unterwerkzeugen möglich, die genau an die Abmessungen der einzelnen Bauelemente angepaßt sind. Im ungünstigsten Fall sind somit für jedes Bauelement ein eigener Greifer und ein eigenes Unterwerkzeug erforderlich.

Der im Anspruch 1 angegebenen Erfindung liegt das Problem zugrunde, ein bestückschattenfreies Unterwerkzeug zum Befestigen von mehrpoligen Bauelementen in Leiterplatten zu schaffen, welches insbesondere auch für IC-Bauelemente geeignet sein soll.

Die mit der Erfindung erzielten Vorteile bestehen insbesondere darin, daß das Umbiegen der Anschlußbeinchen durch einen verfahrbaren Biegestempel bewirkt wird, dessen Verfahrweg programmgesteuert an die jeweilige Bestücklänge der Bauelemente angepaßt werden kann. Die bisher erforderliche Bestücktechnik mit mehreren angepaßten Bestückeinheiten im Bereich der Unterwerkzeuge kann somit entfallen. Oberhalb der Leiterplatte kann dabei das Bestücken der Bauelemente in bekannter Weise mit in der Länge an die Bauelemente angepaßten Greifern vorgenommen werden.

Vorteilhafte Ausgestaltungen der Erfindung sind in den Ansprüchen 2 bis 9 angegeben.

Die Weiterbildung nach Anspruch 2 ermöglicht mit besonders geringem Aufwand eine gesteuerte Linearbewegung des Biegestempels.

Die Ausgestaltung nach Anspruch 3 bietet die Möglichkeit, bei den üblichen Bauelementen mit zwei Reihen von Anschlußbeinchen diese in einem Arbeitsgang umzubiegen.

Gemäß Anspruch 4 kann das Umbiegen der Anschlußbeinchen auf besonders einfache und besonders sichere Weise durch entsprechend geformte Biegeschrägen der Biegestempel vorgenommen werden.

Die Ausgestaltung nach Anspruch 5 ermöglicht eine einfache Anpassung des Abstandes der Biegestempel an verschiedene Abstände zwischen den beiden Reihen der Anschlußbeinchen unterschiedlicher Bauelemente.

Die Weiterbildung nach Anspruch 6 ermöglicht es, die Fahrrichtung der Biegestempel programmgesteuert an die jeweilige Einbaulage der Bauelemente anzupassen.

Gemäß Anspruch 7 kann mit geringem Aufwand das gesamte Unterwerkzeug durch Betätigung der Hubeinrichtung in Arbeits- oder Ruhestellung verfahren werden. Die Ausgestaltung nach Anspruch 8 ermöglicht ein sicheres Erkennen aller Anschlußbeinchen eines Bauelements nach dem Bestückvorgang an der Unterseite einer Leiterplatte. Ein besonders robuster und zuverlässiger pneumatischer Sensor für eine derartige Durchsteckkontrolle der Anschlußbeinchen ist im Anspruch 9 angegeben.

Ein Ausführungsbeispiel der Erfindung ist in der Zeichnung dargestellt und wird im folgenden näher beschrieben.

Es zeigen:
Figur 1 eine perspektivische Darstellung einer Vorrichtung zum Befestigen von Bauelementen in Leiterplatten,
Figur 2 eine stirnseitige Draufsicht auf Bauelement und Biegestempel beim Umbiegen der Anschlußbeinchen eines Bauelements,
Figur 3 eine Draufsicht auf die Biegeschräge eines der in Figur 2 dargestellten Biegestempel und
Figur 4 eine Seitenansicht der Biegeschräge eines der in Figur 2 dargestellten Biegestempel.

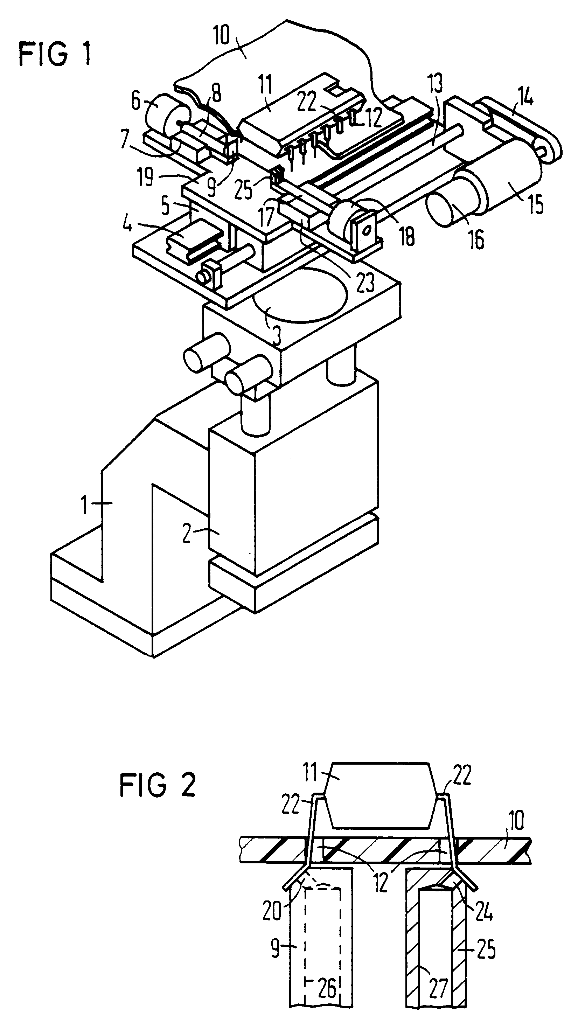

Figur 1 zeigt in perspektivischer Darstellung ein Unterwerkzeug, d. h. eine Vorrichtung zum Befestigen von Bauelementen in Leiterplatten durch Umbiegen der Anschlußbeinchen. Im dargestellten Fall wird ein Bauelement 11, bei welchem es sich um ein IC-Bauelement mit zwei Reihen von Anschlußbeinchen 22 handelt, mit einem in der Zeichnung nicht dargestellten Greifer auf eine Leiterplatte 10 abgesenkt. Hierbei drückt ein Ausdrückstempel das Bauelement 11 aus dem in der Länge an das Bauelement 11 angepaßten Greifer, sobald er lagegenau plaziert ist. Die Anschlußbeinchen 22 werden dabei durch die zugeordneten Bohrungen 12 der Leiterplatte 10 gedrückt und stehen an der Unterseite der Leiterplatte 12 ca. 2 mm vor. Das Bauelement 11 wird dabei mit dem Ausdrückstempel auf die Leiterplatte 10 gedrückt.

Sobald die vorstehend beschriebene Stellung erreicht ist, werden mit Hilfe des in Figur 1 dargestellten Unterwerkzeugs die Anschlußbeinchen 22 zur Befestigung des Bauelements 11 auf der Leiterplatte 10 umgebogen. Hierzu werden zwei im Abstand zueinander angeordnete Biegestempel 9 und 25 an den Anschlußbeinchen 22 entlang bewegt, wobei die aus den Figuren 2 bis 4 ersichtlichen Biegeschrägen 21 der Biegestempel 9 und 25 das Umbiegen der Anschlußbeinchen 22 bewirken.

Die Positionierung der beiden Biegestempel 9 und 25 am Beginn und am Ende des Beinchen-Biegevorganges wird antriebsmäßig mit Hilfe eines Gleichstrommotores 15, eines Spindelantriebes 14 und einer Spindel 13 erreicht. Mechanisch werden die Biegestempel 9 und 25 hierbei lagegenau durch einen Führungsschlitten 5 und eine Führungsschiene 4 geführt. Die aktuelle Lageposition der Biegestempel 9 und 25 ist durch einen am Gleichstrommotor 15 angebrachten Winkelschrittgeber 16 gegeben.

Bei IC-Bauelementen betragen die beiden üblichen Abstände zwischen den beiden Reihen von Anschlußbeinchen 22 entweder 0,3 Zoll oder 0,6 Zoll. Die Biegestempel 9 und 25 können mit Hilfe von Stellzylindern 6 bzw. 18 auf diese beiden Abstände problemlos eingestellt werden. Die beiden Biegestempel 9 und 25, die auf Stellschlitten 8 bzw. 17 angeordnet sind, bewegen sich hierbei in zugeordneten Führungen 7 bzw. 23 programmgesteuert in die entsprechende Endlage. Die beiden Führungen 7 und 23 sind auf einer Befestigungsplatte 19 angeordnet, die ihrerseits von dem bereits erwähnten Führungsschlitten 5 getragen wird.

Zur Anpassung an verschiedene Einbaulagen der Bauelemente 11 kann die Fahrrichtung der beiden Biegestempel 9 und 25 mit Hilfe einer Dreheinrichtung 3 in 0° und 90° programmgesteuert geändert werden.

Mit einer Hubeinrichtung 2 wird das gesamte Unterwerkzeug in Arbeits- und Ruhestellung gefahren. Diese Hubeinrichtung 2 und damit das gesamte Unterwerkzeug ist über einen Befestigungssockel 1 mit dem nicht näher dargestellten Grundgestell des entsprechenden Bestückautomaten verbunden.

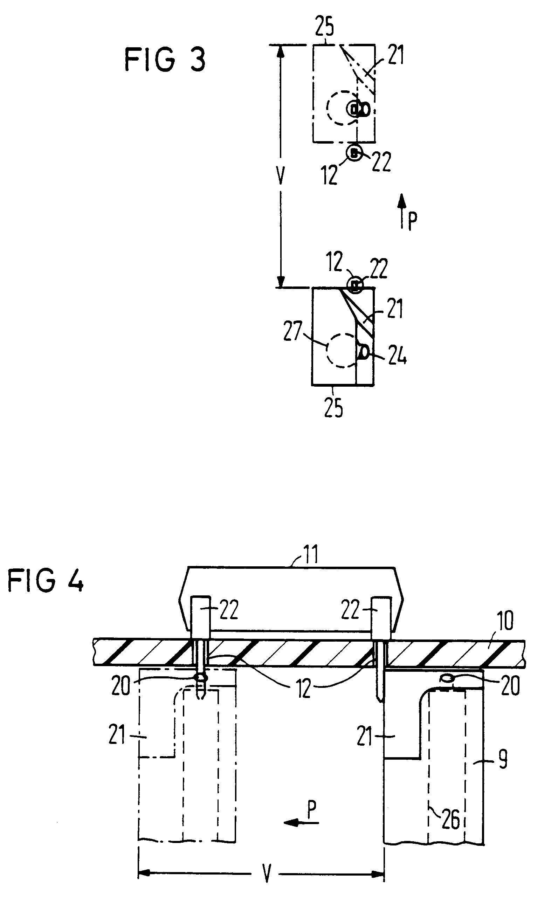

Die Wirkungsweise der beiden Biegestempel 9 und 25 ist insbesondere aus den Figuren 2, 3 und 4 ersichtlich. Dabei zeigt Figur 2, wie die nach unten aus den Bohrungen 12 der Leiterplatte 10 herausragenden Enden der Anschlußbeinchen 22 eines Bauelements 11 durch die beiden Biegestempel 9 und 25 umgebogen sind. Wie dieses Umbiegen der Anschlußbeinchen 22 durch Verfahren der Biegestempel 9 und 25 in Richtung des Pfeiles P bewirkt wird, ist in Figur 3 am Beispiel des Biegestempels 25 dargestellt. Es ist ersichtlich, daß die Biegeschräge 21 des Biegestempels 25 derart geformt ist, daß die Anschlußbeinchen durch die Bewegung in Richtung des Pfeiles P immer weiter nach außen gedrückt werden, bis sie dann gemäß Figur 2 an dem zur Verfahrrichtung P parallelen Bereich der Biegeschräge 21 anliegen. Der von der Länge des jeweiligen Bauelements 11 abhängige Verkramphub bis zum Erreichen der gestrichelt dargestellten Endlage des Biegestempels 25 ist in Figur 3 mit V bezeichnet. Figur 4 zeigt in einer Seitenansicht auf die Biegeschräge 21 des Biegestempels 9 ebenfalls den zum Umbiegen sämtlicher Anschlußbeinchen 22 eines Bauelements 11 erforderlichen Verkramphub V.

Aus den Figuren 2 bis 4 ist auch die Wirkungsweise von in die Biegestempel 9 und 25 integrierten pneumatischen Sensoren ersichtlich, mit welchen alle Anschlußbeinchen 22 eines Bauelements 11 nach dem Bestückvorgang auf der Unterseite der Leiterplatte 10 sicher erkannt werden können. Zur Bildung dieser pneumatischen Sensoren befinden sich in den Biegestempeln 9 und 25 Meßkammern 26 bzw. 27, deren Meßdüsen 20 bzw. 24 jeweils aus dem zur Verfahrrichtung P parallelen Verlauf der Biegeschrägen 21 ausmünden. In die Meßkammern 26 und 27 wird jeweils Druckluft mit einem Druck von beispielsweise 0,2 bar eingeleitet, so daß aus den Meßdüsen 20 bzw. 24 jeweils ein Luftstrom mit konstantem Druck austritt. Bewegen sich nun die beiden Biegestempel 9 und 25 an den Anschlußbeinchen 22 entlang und verbiegen diese, so werden die Meßdüsen 20 bzw. 24 von den einzelnen Anschlußbeinchen 22 jeweils kurzfristig abgedeckt. Die resultierenden Staudruckerhöhungen in den Meßkammern 26 bzw. 27 werden durch in der Zeichung nicht näher dargestellte Drucksensoren erfaßt und die Ausgangssignale dieser Drucksensoren elektronisch ausgewertet. Die Anzahl der beim Biegevorgang sämtlicher Anschlußbeinchen 22 eines Bauelements 11 entstandenen Impulse wird dann mit einer entsprechend dem Bestückprogramm hinterlegten Sollvorgabe verglichen. Stimmen dann Ist-Wert und Soll-Vorgabe nicht überein, so liegt eine Fehlbestückung vor und es wird ein Reparaturzyklus des Bestückautomaten ausgelöst.

Im vorstehend beschriebenen Ausführungsbeispiel werden durch die Biegeschrägen 21 der beiden Biegestempel 9 und 25 jeweils Außenbiegungen der Anschlußbeinchen 22 bewirkt, so wie es insbesondere aus Figur 2 ersichtlich ist. Durch eine entsprechende Anordnung der Biegeschrägen an den Biegestempeln können jedoch auch in vergleichbarer Weise Innenbiegungen der Anschlußbeinchen bewirkt werden.

## Patentansprüche

1. Vorrichtung zum Befestigen von mehrpoligen Bauelementen (11) in Leiterplatten (10) durch Umbiegen der in mindestens einer Reihe angeordneten Anschlußbeinchen (22) der Bauelemente (11) auf der Unterseite der Leiterplatten (10),
**gekennzeichnet durch**
mindestens einen Biegestempel (9, 25), der derart in Richtung einer zugeordneten Reihe von Anschlußbeinchen (22) verfahren wird, daß die Anschlußbeinchen (22) nacheinander umgebogen werden.

2. Vorrichtung nach Anspruch 1,
**dadurch gekennzeichnet,**
daß der Biegestempel (9, 25) auf einem Führungsschlitten (5) angeordnet ist.

3. Vorrichtung nach Anspruch 2,
**dadurch gekennzeichnet,**
daß der Führungsschlitten (5) zwei im Abstand zueinander angeordnete Biegestempel (9, 25) trägt.

4. Vorrichtung nach einem der vorhergehenden Ansprüche, **dadurch gekennzeichnet,**
daß der Biegestempel (9, 25) mit einer Biegeschräge (21) zum Umbiegen der Anschlußbeinchen (22) versehen ist.

5. Vorrichtung nach Anspruch 2, 3 oder 4,
**dadurch gekennzeichnet,**
daß der Biegestempel (9, 25) mit Hilfe eines Stellzylinders (6, 18) quer zur Bewegungsrichtung des Führungsschlittens (5) verstellbar ist.

6. Vorrichtung nach einem der Ansprüche 2 bis 5,
**dadurch gekennzeichnet,**
daß der Führungsschlitten (5) auf einer Dreheinrichtung (3) angeordnet ist.

7. Vorrichtung nach Anspruch 6,
**dadurch gekennzeichnet,**
daß die Dreheinrichtung (3) auf einer Hubeinrichtung (2) angeordnet ist.

8. Vorrichtung nach einem der vorhergehenden Ansprüche,
**dadurch gekennzeichnet,**
daß in die Biegestempel (9, 25) ein Sensor zum Erkennen der aus der Leiterplatte (10) herausragenden Anschlußbeinchen (22) integriert ist.

9. Vorrichtung nach den Ansprüchen 4 und 8,
**dadurch gekennzeichnet,**
daß der Sensor als pneumatischer Sensor ausgebildet ist, dessen Meßdüse (20, 24) aus der Biegeschräge (21) des Biegestempels (9, 25) ausmündet.

## Claims

1. Device for fastening multipole components (11) in printed circuit boards (10) by bending the connecting legs (22), arranged in at least one row, of the components (11) on the underside of the printed circuit boards (10), characterized by at least one bending die (9, 25) which is displaced in the direction of an assigned row of connecting legs (22) in such a manner that the connecting legs (22) are bent one after the other.

2. Device according to Claim 1, characterized in that the bending die (9, 25) is arranged on a guide block (5).

3. Device according to Claim 2, characterized in that the guide block (5) carries two bending dies (9, 25) arranged at a distance from one another.

4. Device according to one of the preceding claims, characterized in that the bending die (9, 25) is provided with a bending slope (21) for bending the connecting legs (22).

5. Device according to Claim 2, 3 or 4, characterized in that the bending die (9, 25) is displaceable transversely to the direction of movement of the guide block (5) by means of an actuating cylinder (6, 18).

6. Device according to one of Claims 2 to 5, characterized in that the guide block (5) is arranged on a rotating appliance (3).

7. Device according to Claim 6, characterized in that the rotating appliance (3) is arranged on a lifting appliance (2).

8. Device according to one of the preceding claims, characterized in that a sensor for detecting the connecting legs (22) projecting out of the printed circuit board (10) is integrated in the bending die (9, 25).

9. Device according to Claims 4 and 8, characterized in that the sensor is constructed as pneumatic sensor whose measuring nozzle (20, 24) discharges out of the bending slope (21) of the bending die (9, 25).

## Revendications

1. Dispositif de fixation de composants (11) multipolaires à des plaques de circuit imprimé (10) par pliage des pattes (22) des composants (11) disposées en au moins une rangée sur la face inférieure des plaques de circuit imprimé (10), caractérisé par au moins un poinçon de pliage (9, 25) qui est déplacé en direction d'une rangée associée de pattes (22) de raccordement de telle sorte que les pattes (22) sont pliées les unes après les autres.

2. Dispositif selon la revendication 1, caractérisé en ce que le poinçon de pliage (9, 25) est monté sur un chariot de guidage (5).

3. Dispositif selon la revendication 2, caractérisé en ce que le chariot de guidage (5) porte deux poinçons de pliage (9, 25) disposés à distance l'un de l'autre.

4. Dispositif selon l'une des revendications précédentes, caractérisé en ce que le poinçon de pliage (9, 25) est muni d'un biseau de pliage (21) pour le pliage des pattes (22) de raccord.

5. Dispositif selon la revendication 2, 3 ou 4, caractérisé en ce que le poinçon de pliage (9, 25) est réglable transversalement par rapport à la direction de mouvement du chariot de guidage (5) à l'aide d'un vérin de réglage (6, 18).

6. Dispositif selon l'une des revendications 2 à 5, caractérisé en ce que le chariot de guidage (5) est monté sur un dispositif de rotation (3).

7. Dispositif selon la revendication 6, caractérisé en ce que le dispositif de rotation (3) est monté sur un dispositif de levage (2).

8. Dispositif selon l'une des revendications précédentes, caractérisé en ce que dans le poinçon de pliage (9, 25) est intégré à un capteur d'identification des pattes (22) de raccordement qui font saillie de la plaque de circuit imprimé (10).

9. Dispositif selon la revendication 4 ou 8, caractérisé en ce que le capteur est agencé sous la forme d'un capteur pneumatique dont la buse de mesure (20, 24) débouche du biseau de pliage (21) du poinçon de pliage (9, 25).
